Europäisches Patentamt

European Patent Office

Office européen des brevets

(11) Publication number: 0 498 895 A1

## EUROPEAN PATENT APPLICATION
### published in accordance with Art. 158(3) EPC

(21) Application number: 91915599.4

(22) Date of filing: 04.09.91

(86) International application number:
PCT/JP91/01181

(87) International publication number:
WO 92/04774 (19.03.92 92/07)

(51) Int. Cl.5: H03K 5/15, G06F 1/04,
G11C 11/34

(30) Priority: 05.09.90 JP 236557/90

(43) Date of publication of application:
19.08.92 Bulletin 92/34

(84) Designated Contracting States:
DE FR GB

(71) Applicant: FUJITSU LIMITED
1015, Kamikodanaka Nakahara-ku
Kawasaki-shi Kanagawa 211(JP)
Applicant: FUJITSU VLSI LIMITED
1844-2, Kozoji-cho 2-chome
Kasugai-shi Aichi 487(JP)

(72) Inventor: KURODA, Susumu, Fujitsu VLSI
Limited
1844-2, Kozoji-cho 2-chome Kasugai-shi
Aichi 487(JP)
Inventor: SEKI, Teruo, Fujitsu VLSI Limited
1844-2, Kosoji-cho 2-chome Kasugai-shi
Aichi 487(JP)

(74) Representative: Rackham, Stephen Neil et al
GILL JENNINGS & EVERY 53-64 Chancery
Lane
London WC2A 1HN(GB)

(54) SEMICONDUCTOR INTEGRATED CIRCUIT.

(57) A clock buffer which can output stably plural clock signals provided with predetermined time differences and generated from a reference clock signal. Plural informations stored in a predetermined storing means (4) are read out in synchronism with a predetermined clock pulse generated by a clock generating means (11). The read out information are transferred successively by synchronizing plural latch circuits (9, 10) of a latching means (30) with the predetermined clock pulse, and the information is outputted to another arithmetic processing circuit via a predetermined outputting means (31). The clock generating means (11) has a first pulse generating circuit (19) which outputs a first clock signal (CLK1) according to an inputted reference clock signal (CLK), and a second pulse generating circuit (20) which outputs a second clock signal (CLK2), responding to the first clock signal (CLK1).

Fig. 5

TECHNICAL FIELD

This invention relates to a semiconductor integrated circuit for providing predetermined information from a storage means through a plurality of latch circuits, and particularly to a semiconductor integrated circuit having a clock buffer, i.e., a clock signal generation means for generating a plurality of clock signals having predetermined time differences according to a given clock signal.

BACKGROUND ART

A semiconductor storage device called a memory circuit is a semiconductor integrated circuit involving memory cells and peripheral circuits as well as circuits that are controlled according to predetermined clock signals.

The semiconductor integrated circuit of this kind employs different clock signals at the same time or with predetermined delays. Accordingly, it is required to set the delays between the different clock signals.

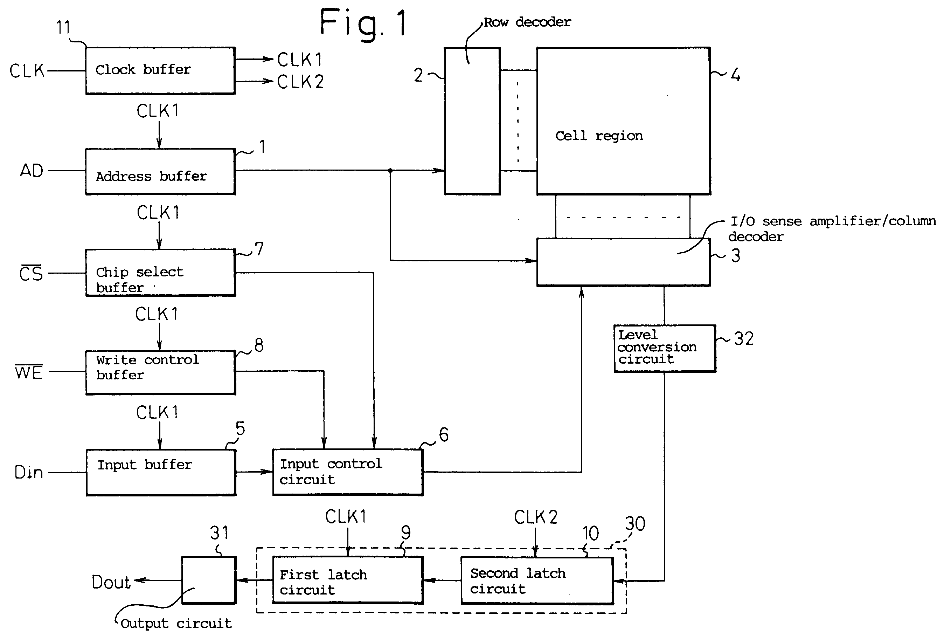

The reason why the correct delays are required between the clock pulse signals will be explained with reference to a conventional semiconductor storage device shown in Fig. 1.

An address buffer 1 receives an address selection signal AD from an external circuit. The address buffer 1 provides an address signal to a row decoder 2 and an I/O sense amplifier/column decoder 3. According to the address signal (ADD), the row decoder 2 and I/O sense amplifier/column decoder 3 provide output signals for selecting a memory cell in a cell region 4.

To write data into a given memory cell in the cell region 4, input data Din is provided to an input buffer 5 and then to an input control circuit 6. When a chip select buffer 7 and a write control buffer 8 provide the input control circuit 6 with output signals for a write operation, the input data is written into the memory cell that has been selected in the cell region 4 in the way mentioned above, through the I/O sense amplifier/column decoder 3.

To read data out of a given memory cell in the cell region 4, the memory cell is selected in the way mentioned above, and the data is read out of the memory cell and passed through the I/O sense amplifier/column decoder 3 to a data transfer circuit comprising first and second latch circuits 9 and 10. The latch circuits successively latch the data, and the first latch circuit 9 provides output data Dout through an output circuit 31.

A clock buffer, i.e., a clock generation means 11 provides clock pulse signals for controlling the operation timing of the respective circuits. The clock buffer receives a reference clock signal CLK from an external circuit, and according to the reference clock signal CLK, provides a first clock signal CLK1 and a second clock signal CLK2, which has a predetermined time delay relative to the first clock signal. The first latch circuit 9 operates according to the first clock signal CLK1, and the second latch circuit 10 according to the second clock signal CLK2. In a read operation, the first and second latch circuits 9 and 10 sequentially operate according to the first clock signal CLK1 and the following second clock signal CLK2, to sequentially provide output data Dout.

The address buffer 1, input buffer 5, chip select buffer 7, write control buffer 8, and first latch circuit 9 operate according to the first clock signal CLK1. The second latch circuit 10 operates according to the second clock signal CLK2. During write and read operations, the first clock signal CLK1 drives the address buffer 1, input buffer 5, chip select buffer 7, write control buffer 8, and first latch circuit 9.

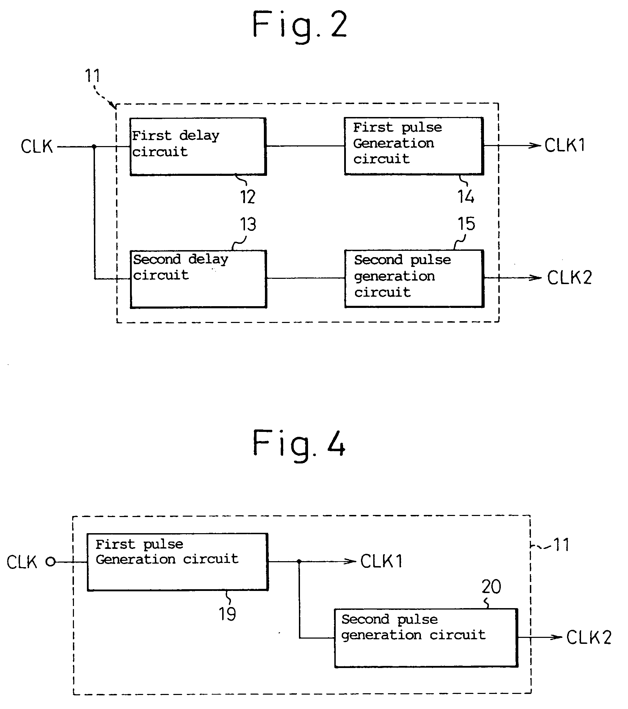

The clock buffer 11 may be configured as shown in Fig. 2. First and second delay circuits 12 and 13 receive the reference clock signal CLK, and according to output signals of the delay circuits 12 and 13, first and second pulse generation circuits 14 and 15 provide the clock signals CLK1 and CLK2, respectively. A delay time of the first delay circuit 12 is larger than that of the second delay circuit 13 so that the first clock signal CLK1 is first provided and the second clock signal CLK2 thereafter.

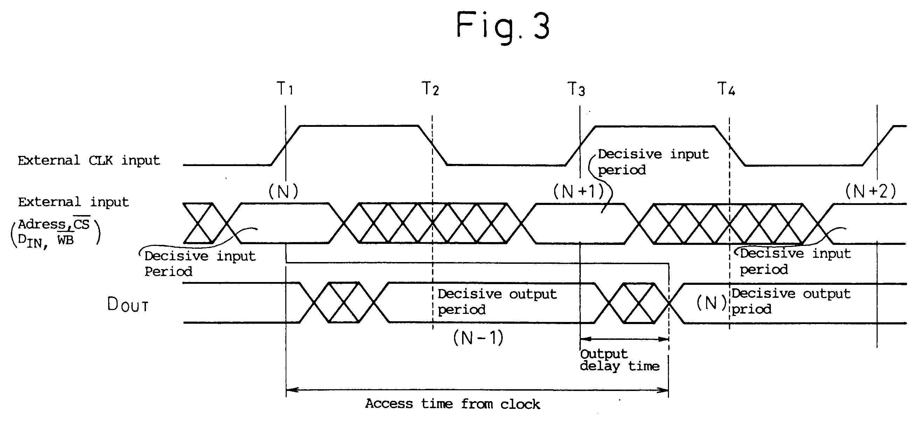

The memory in the semiconductor storage device of Fig. 1 employs a full synchronization STRAM. Figure 3 shows a principle of reading data out of the memory.

Figure 3 shows waveforms of the clock signal, external input, and data output of the RR-type full synchronization STRAM. At time T1, the clock signal rises up to a predetermined level, and an address CS, i.e., the external input, and data N in the data input Din are fetched. When the clock signal again rises at time T3, the fetched data N is provided outside. Namely, at each rise of the clock signal, data that has been fetched at the preceding rise of the clock signal is provided outside.

In this way, the semiconductor integrated circuit with such arrangement controls operations of circuit elements according to a plurality of clock signals having predetermined time differences. These clock signals are produced by a clock buffer according to a reference clock signal. Namely, it is necessary to prepare a clock buffer that generates, according to a reference clock signal, a plurality of clock signals having predetermined time differences.

As mentioned above, the semiconductor integrated circuit involving the synchronous semiconductor memory employs the first and second latch circuits as shown in Fig. 1, to send data from the memory to the outside. The latch circuits fetch data from the memory according to the first clock signal, and provide the data outside according to the next clock signal. In the output buffer of Fig. 1, the first latch circuit fetches data from the second latch circuit and provides it to the output circuit according to the first clock signal. Thereafter, new data is read out of the memory and fetched by the second latch circuit according to the second clock signal.

This data is fetched by the first latch circuit and provided to the output circuit, according to the next first clock signal.

The synchronous semiconductor memory employing such two latch circuits fetch data (information) at one point during a rise of the clock signal as explained with reference to Fig. 3, so that a cycle of the clock signal can be shortened to reduce the period from receiving the clock signal to providing the data.

Since internal latch circuits latch input data, the input data can be received with no error even if the data skews slightly.

The first and second clock signals mentioned above must have a predetermined time delay between them. If the clock signals overlap each other for some reason, the first and second latch circuits of Fig. 1 will be simultaneously ON. In this case, new data fetched by the second latch circuit will immediately pass through the first latch circuit to the output circuit. This may provide erroneous information and a malfunction.

It is necessary, therefore, to surely and correctly set a delay time between the first and second clock signals.

According to the conventional clock signal generation circuit shown in Fig. 2, the delay circuits 12 and 13 of the clock buffer have manufacture fluctuations in parameters, creating a risk of reducing the delay time difference between the delay circuits 12 and 13. In this case, the first and second latch circuits 9 and 10 may malfunction.

An object of the invention is to provide a clock buffer that stably generates, according to a reference clock signal, a plurality of clock signals having predetermined time differences.

DISCLOSURE OF THE INVENTION

To achieve the object, the invention provides a semiconductor integrated circuit having the following basic technical configuration.

Namely, the semiconductor integrated circuit has first and second pulse signal generation circuits for providing pulse signals having predetermined pulse widths in response to a rise or a fall of an input signal. The second pulse signal generation circuit starts to provide a second pulse signal in response to a first pulse signal provided by the first pulse signal generation circuit in response to the input signal. The semiconductor integrated circuit has a storage means for storing a plurality of data. The semiconductor integrated circuit reads the data according to clock pulses provided by a clock generation means, and sequentially transfers the data according to the clock pulses through a latch means comprising a plurality of latch circuits connected in series. The semiconductor integrated circuit then provides the data to another operational processing circuit through an output means. The clock generation means comprises the first pulse signal generation circuit for providing a first clock signal (CLK1) according to the input reference clock signal (CLK), and the second clock pulse signal generation circuit for providing a second clock signal (CLK2) in response to the first clock signal (CLK1).

The semiconductor integrated circuit of the invention is characterized in that it produces a second pulse having a given pulse width in response to a change in a first pulse occurring at a given timing.

BRIEF DESCRIPTION OF THE DRAWINGS

Figure 1 is a view showing an example of a conventional semiconductor integrated circuit having a semiconductor storage means.

Figure 2 is a view showing an example of a clock generation means employed by the conventional semiconductor integrated circuit.

Figure 3 is a view explaining an operation of an STRAM employed by the conventional semiconductor storage means.

Figure 4 is a view explaining a principle of a clock generation means according to the invention.

Figure 5 is a view showing a clock generation means according to an embodiment of the invention.

Figure 6 is a view explaining an operation of the clock generation means of Fig. 5 according to the invention.

Figure 7 is a view showing an example of a semiconductor integrated circuit employing the clock generation means according to the invention.

Figure 8 is a view explaining an operation of the semiconductor integrated circuit of Fig. 7.

Figure 9 is a view showing an example of a sense amplifier circuit connected to the storage means of the semiconductor integrated circuit according to the invention.

Figure 10 is a view showing an example of a level conversion circuit connected to the sense amplifier of the semiconductor integrated circuit according to the invention.

Figure 11 is a view showing another configuration of the level conversion circuit connected to the sense amplifier of the semiconductor integrated circuit according to the invention.

Figure 12 is a view showing other examples of first and second latch circuits employed by the semiconductor integrated circuit according to the invention.

BEST MODE OF CARRYING OUT THE INVENTION

A semiconductor integrated circuit according to an embodiment of the invention will be explained in detail with reference to the drawings.

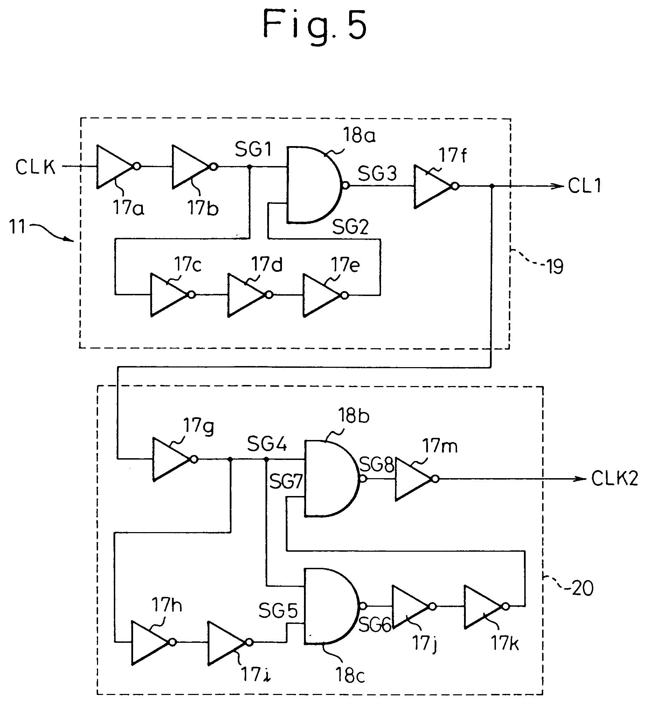

Figure 4 shows a principle of a clock generation means according to the invention.

A clock buffer comprises a first pulse generation circuit 19 for providing a first clock signal CLK1 according to an input reference clock signal CLK, and a second clock pulse generation circuit 20 for providing a second clock signal CLK2 after receiving the first clock signal CLK1.

In this arrangement, the second pulse generation circuit 20 provides the second clock signal CLK2 after detecting an end of the first clock signal CLK1, so that a predetermined time difference is always secured between the first and second clock signals CLK1 and CLK2.

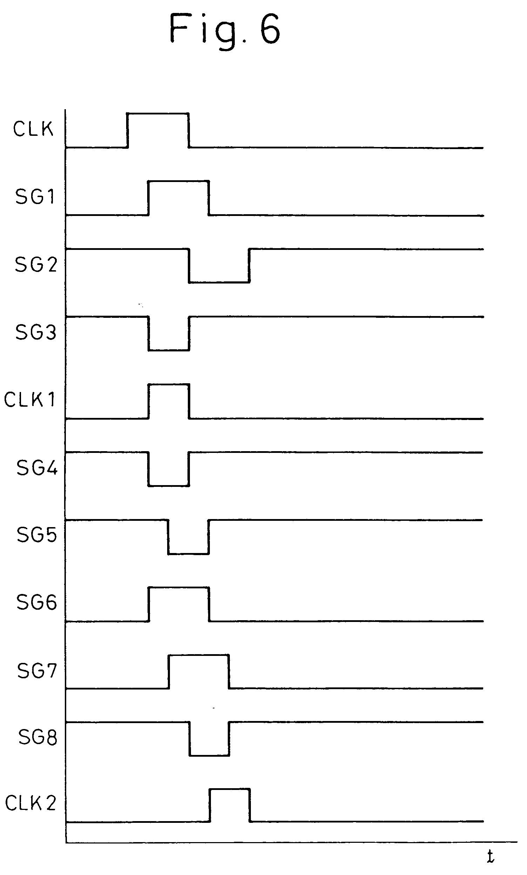

A concrete example of a clock generation means of the invention will be explained with reference to Figs. 5 and 6.

Figure 5 shows a clock buffer 16. A reference input signal CLK is passed through two inverters 17a and 17b and supplied to one input terminal of a NAND circuit 18a. A signal from an inverter 17b is passed through three inverters 17c, 17d, and 17e and supplied to another input terminal of the NAND circuit 18a. An output terminal of the NAND circuit 18a provides a first clock signal CLK1 through an inverter 17f. The inverters 17a to 17f and NAND circuit 18a form a first pulse generation circuit 19.

The output signal of the inverter 17f is passed through an inverter 17g and supplied to input terminals of NAND circuits 18b and 18c. The output signal of the inverter 17g is also passed through inverters 17h and 17i and supplied to another input terminal of the NAND circuit 18c. An output signal of the NAND circuit 18c is passed through inverters 17j and 17k and supplied to another input terminal of the NAND circuit 18b. An output terminal of the NAND circuit 18b provides a second clock signal CLK2 through an inverter 17m. The inverters 17g to 17m and NAND circuits 18b and 18c form a second pulse generation circuit 20.

An operation of the clock buffer 11 will be explained with reference to Fig. 5.

After the input signal CLK is supplied to the inverter 17a, the inverter 17b provides an output signal SG1, which has the same phase and a time difference with respect to the input signal, to the input terminal of the NAND circuit 18a. The other input terminal of the NAND circuit 18a receives from the inverter 17e a further delayed output signal SG2 having an opposite phase. The NAND circuit 18a provides an output signal SG3 that falls to level L only when both the output signals SG1 and SG2 rise to level H. The inverter 17f inverts the output signal SG3 and provides the first clock signal CLK1.

On the other hand, the input terminals of the NAND circuits 18b and 18c receive an output signal SG4, which is an inversion of the first clock signal CLK1, from the inverter 17g. The other input terminal of the NAND circuit 18c receives an output signal SG5, which has the same phase and a time difference relative to the output signal SG4, through the inverters 17h and 17i. The NAND circuit 18c provides an output signal SG6 that rises to level H when any one of the output signals SG4 and SG5 is at level L. The output signal SG6 is passed through the inverters 17j and 17k and provided as an output signal SG7 to the other input terminal of the NAND circuit 18b.

The NAND circuit 18b provides an output signal SG8, which falls to level L when both the output signals SG4 and SG7 rise to level H. Namely, the output signal SG8 rises in response to a fall of the first clock signal CLK1. The output signal SG8 is inverted by the inverter 17m and provided as the second clock signal CLK2.

As explained above, the clock buffer 16 provides the first clock signal CLK1 according to the reference clock signal CLK, and in response to a fall of the first clock signal CLK1, provides the second clock signal CLK2, thereby always securing a constant time difference between the first and second clock signals CLK1 and CLK2. This clock buffer 16 is employed for the semiconductor storage device, to surely prevent malfunctions of the first and second latch circuits 9 and 10.

The pulse generation circuits of the invention generate the first clock signal, and after confirming an OFF state of the first clock signal, i.e., after confirming that the first clock signal has disappeared, produces the second clock signal. There are many techniques for confirming the disappearance of the first clock signal. One preferable technique generates the second clock signal (CLK2) when the first clock signal (CLK1) provided by the first pulse generation circuit is shifted to a predetermined level. Another technique may detect a fall of the first clock signal (CLK1) provided by the first pulse generation circuit, and then generate the second clock signal (CLK2).

Namely, the invention produces the second clock signal after the first clock signal completely falls. As a result, the second clock signal will never be produced while the first clock signal is active.

According to the invention, the first clock signal is used to fetch data from the second latch circuit, latch the data, and provide the data to the output circuit. For this purpose, the latch circuit is only required to be turned on, so that the width of the first clock signal may be relatively short. According to the invention, it is preferable to provide a write pulse generation circuit for activating the latch circuit.

On the other hand, the second clock signal functions to read data from the memory of the storage means. Since the data handled by the memory is analog, a certain time is needed for reading the data.

Accordingly, the width of the second clock signal is required to be wider than that of the first clock signal, so that the data can be surely read out of the memory.

Namely, the second pulse generation circuit of the invention is preferably formed to generate the second clock signal (CLK2) having a wider signal width than the first clock signal (CLK1).

As explained above, the latch means of the invention includes at least two latch circuits connected in series, in which a first latch circuit is disposed close to the output means, and a second latch circuit close to the storage means.

According to the invention, the first latch circuit is controlled by the first clock signal (CLK1), and the second latch circuit by the second clock signal (CLK2).

The storage means employed by the semiconductor integrated circuit of the invention comprises, for example, a row decoder, a column decoder, memory cells, and a sense amplifier/write buffer. The row decoder and column decoder are controlled by an address buffer, which is controlled by the first clock signal (CLK1). The sense amplifier/write buffer is controlled by an input buffer and by a write pulse generation circuit, which provides a write pulse in response to a write buffer and a chip select buffer.

An output of the sense amplifier/write buffer is connected to the latch means through a level conversion means.

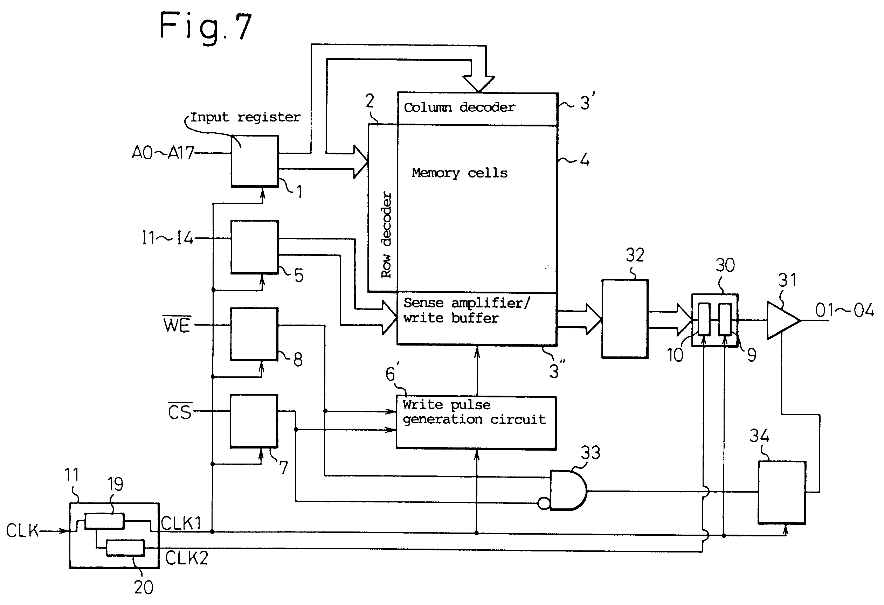

Figure 7 shows a semiconductor integrated circuit according to an embodiment of the invention. This figure corresponds to Fig. 1 showing the prior art.

In the semiconductor integrated circuit of Fig. 7, a storage means 4 stores a plurality of data. A clock pulse generation means 11 generates clock pulses, in response to which data are read out of the storage means 4. The read data are sequentially transferred to a latch means 30 according to the clock pulses. The latch means 30 comprises latch circuits 9 and 10 connected in series. The data in the latch means are provided to another operational processing circuit through an output means 31. The clock generation means 11 comprises a first pulse generation circuit 19 for providing a first clock signal (CLK1) according to an input reference clock signal (CLK), and a second pulse generation circuit 20 for providing a second clock signal (CLK2) in response to the first clock signal (CLK1).

Figure 7 differs from Fig. 1 in that a column decoder 3' and a sense amplifier/write buffer 3'' are separately disposed and a write pulse generation circuit 6' is arranged instead of the input control circuit 6.

In Fig. 7, a level conversion circuit 32 is disposed after the sense amplifier. A write control buffer (WE) 8 and a chip select buffer (CS) 7 are connected to an AND gate circuit 33. An output control circuit 34 is arranged between the AND gate circuit 33 and the output circuit 31. The AND gate circuit 33 is a logic gate for providing a logic of the CS and WE, to control the circuit 34. When the CS is H or when the WE is L, the AND gate circuit 33 activates the output control circuit 34 to provide a high-impedance output.

The circuit 34 is commonly one used for a standard memory, to turn OFF an output transistor Tr.

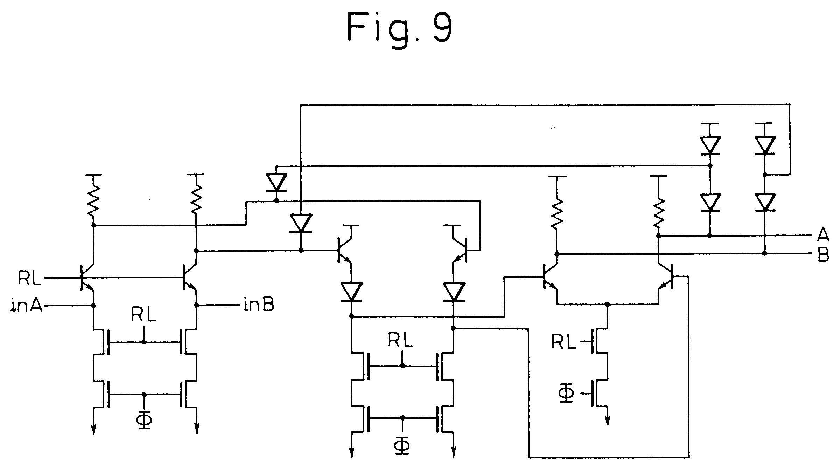

Figure 9 shows an example of a sense amplifier used for the invention.

The sense amplifier shown in the figure has a known configuration. Data from a memory cell is provided to input terminals inA and inB, properly amplified, and supplied to the following level conversion circuit from output terminals A and B.

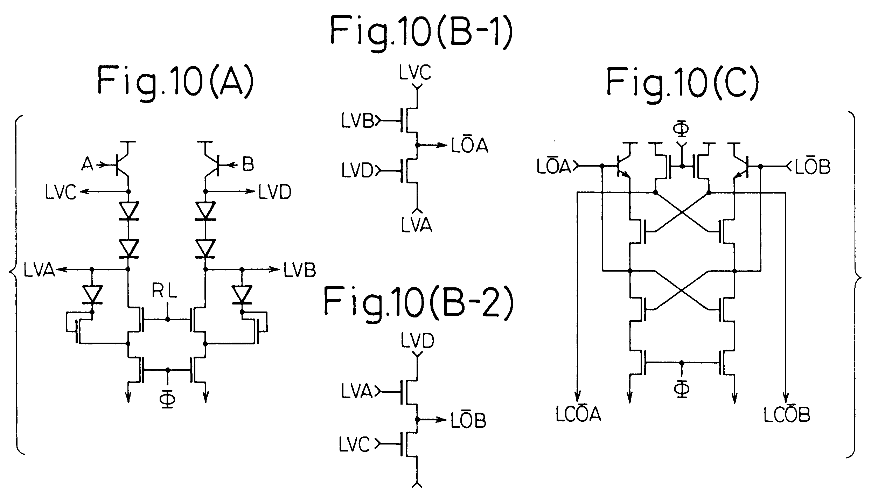

Figure 10 shows an example of a level conversion circuit used for the invention. This circuit comprises circuits A, B, and C as shown in the figure.

The data from the output terminals A and B of the sense amplifier are provided to input terminals A and B of the circuit of Fig. 10(A). This circuit provides data from output terminals LVA and LVB.

The data from the output terminals LVA and LVB are supplied to input terminals LVA and LVB of the circuits of Figs. 10(B-1) and 10(B-2), respectively. The circuit of Fig. 10(B-1) provides an output /LOA, and the circuit of Fig. 10(B-2) provides an output /LOB.

The outputs /LOA and /LOB are supplied to input terminals /LOA and /LOB of the circuit of Fig. 10(C), respectively. This circuit provides output signals /LCOA and /LCOB.

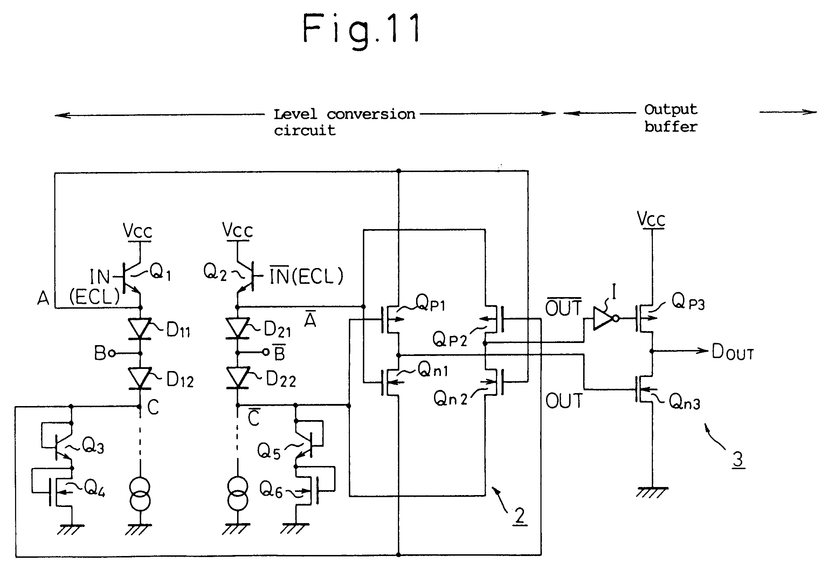

The present invention may employ a level conversion circuit of Fig. 11.

Details of operation of this level conversion circuit are disclosed in Japanese Patent Application No. 3-56886.

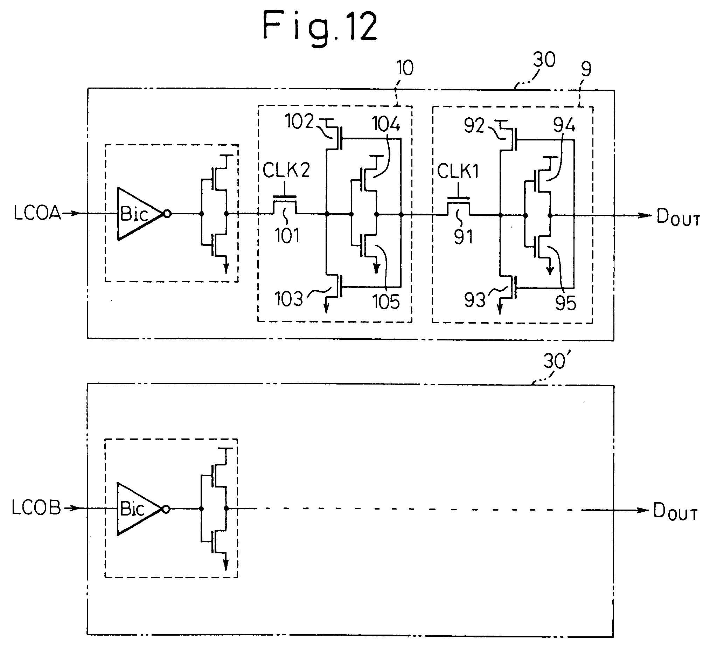

Figure 12 shows another example of a latch means used for the invention. Latch circuits of the latch means comprise MOSFETs 91 and 101 for carrying out switching actions in response to clock signals, and each four MOSFETs 92 to 95 and 102 to 105.

The invention arranges two such latch means parallel with each other. The output signal /LCOA from the level conversion circuit is supplied to an input circuit of one of the latch means, and the output signal /LCOB from the level conversion circuit is supplied to an input circuit of the other latch means.

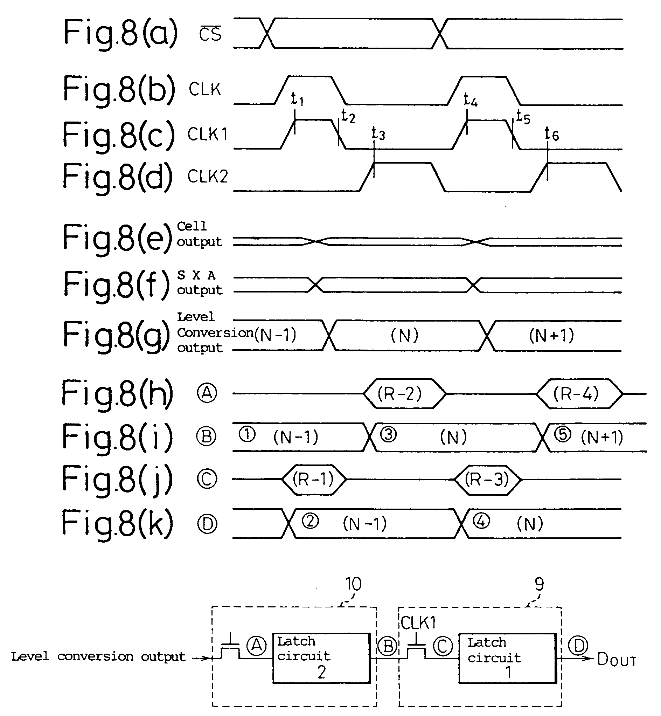

An operation of the semiconductor integrated circuit of the invention shown in Fig. 7 will be explained with reference to waveforms shown in Fig. 8.

The address data CS and the reference clock signal have waveforms a and b, respectively.

According to the reference clock signal having the wave form b, the clock generation means of the invention generates the first clock signal CLK1 having a waveform c and the second clock signal CLK2 having a waveform d with a delay time being secured between the two clock signals.

Data read out of a memory cell according to the address data has a waveform e. According to this data, the sense amplifier and level conversion circuit provide outputs having waveforms f and g, respectively.

Under these conditions, the first and second latch circuits 9 and 10 of the latch means of the invention shown at the bottom of Fig. 8 receive the first and second clock signals CLK1 and CLK2, respectively, to latch output data N-1, N, N+1, N+2, ... from the level conversion circuit and provide them to the output circuit. Firstly, the first clock signal CLK1 becomes ON at time t1 to activate the first latch circuit 9 ((R-1) in a waveform j). As indicated with (1) in a waveform i, the data (N-1) latched in the second latch circuit 10 is provided to the output Dout through the first latch circuit 9. At the same time, the same data is latched in the first latch circuit 9 ((2) in a waveform k).

When the first clock signal CLK1 falls at time t2, the second clock signal CLK2 becomes ON at time t3. With the first latch circuit 9 being closed, the second latch circuit 10 is activated as indicated with R-2 in a waveform h, so that the second latch circuit 10 fetches the output data N from the level conversion circuit as indicated with (3) in the waveform i and latches the same.

After the second clock signal CLK2 falls, the first clock signal CLK1 again turns ON at time t4. Then, as indicated with R-3 in the waveform j, the first latch circuit 9 transfers the data N from the second latch circuit 10 to the output Dout, and at the same time, latches the same data in itself ((4) in the waveform k).

Thereafter, the first clock signal CLK1 falls at time t5, and the second clock signal CLK2 turns ON at time t6. With the first latch circuit 9 being closed, the second latch circuit 10 operates as indicated with R-4 in the waveform h, to fetch the data N+1 from the level conversion circuit and latch the same.

The above operations are repeated to read the required data from the memory and provide the data outside.

As explained above in detail, the present invention provides a clock buffer that stably generates a plurality of clock signals having predetermined time differences according to a reference clock signal.

The semiconductor integrated circuit of the invention is applicable not only to full synchronous memories but also to asynchronous memories.

## Claims

1. A semiconductor integrated circuit comprising first and second pulse signal generation circuits that start generating pulse signals in response to a rising edge or a falling edge of an input signal, to provide pulse signals having predetermined pulse widths, wherein the second pulse signal generation circuit starts to provide a second pulse signal after the first pulse signal generation circuit completely sends a first pulse signal in response to the input signal.

2. A semiconductor integrated circuit according to claim 1, having a storage means for storing a plurality of data, a clock generation means for generating clock pulses according to which the data are read, a latch means having a plurality of latch circuits that are connected in series and through which the read data are sequentially transferred according to the clock pulses, and an output means through which the data in the latch means are provided to another operational processing circuit, characterized in that the clock generation means includes first and second pulse signal generation circuits that start generating pulse signals in response to a rising edge or a falling edge of an input signal, to provide pulse signals having predetermined pulse widths; the second pulse signal generation circuit starting to provide a second pulse signal after the first pulse signal generation circuit completely sends a first pulse signal in response to the input signal.

3. A semiconductor integrated circuit according to claim 1 or 2, in which the second pulse generation circuit provides the second clock signal (CLK2) after detecting a fall of the first clock signal (CLK1) generated by the first pulse generation circuit.

4. A semiconductor integrated circuit according to any one of claims 1 to 3, wherein the second clock signal (CLK2) provided by the second pulse generation circuit has a wider signal width than the first clock signal (CLK1).

5. A semiconductor integrated circuit according to claim 1 or 2, wherein the latch means has at least two latch circuits connected in series.

6. A semiconductor integrated circuit according to claim 5, wherein the first latch circuit is disposed close to the output means, and the second latch circuit is disposed close to the storage means.

7. A semiconductor integrated circuit according to claim 1 or 2, wherein the first latch circuit is controlled by the first clock signal (CLK1), and the second latch circuit is controlled by the second clock signal (CLK2).

8. A semiconductor integrated circuit according to claim 1 or 2, wherein the storage means comprises a row decoder, a column decoder, memory cells, and a sense amplifier/write buffer.

9. A semiconductor integrated circuit according to claim 8, wherein the row decoder and column decoder are controlled by an address buffer that is controlled by the first clock signal (CLK1), and the sense amplifier/write buffer is controlled by an input buffer and by a write pulse generation circuit, that generates a write pulse in response to a write buffer and a chip select buffer.

10. A semiconductor integrated circuit according to claim 9, wherein an output of the sense amplifier/write buffer is provided to the latch means through a level conversion means.

Fig. 1

EP 0 498 895 A1

# Fig. 2

```
        11
CLK ─────┬──────→ ┌──────────────┐          ┌──────────────┐
         │        │ First delay  │          │ First pulse  │
         │        │ circuit      │──────────│ Generation   │──────→ CLK1
         │        │              │          │ circuit      │
         │        └──────────────┘          └──────────────┘
         │               12                        14
         │                                          15
         │               13
         │        ┌──────────────┐          ┌──────────────┐
         └──────→ │ Second delay │          │ Second pulse │
                  │ circuit      │──────────│ generation   │──────→ CLK2
                  │              │          │ circuit      │
                  └──────────────┘          └──────────────┘
```

# Fig. 4

```
                                                              ~11
CLK o────→ ┌─────────────────────┐
           │ First pulse         │
           │ Generation circuit  │──────┬──→ CLK1
           │                     │      │
           └─────────────────────┘      │
                      19                 │        20
                                         │   ┌──────────────────┐
                                         └──→│ Second pulse     │
                                             │ generation circuit│──→ CLK2
                                             │                  │
                                             └──────────────────┘
```

# Fig. 3

External CLK input

External input
$\left(\begin{array}{c}\text{Adress,}\overline{\text{CS}}\\ D_{IN},\ \overline{WB}\end{array}\right)$

Decisive input
Period

(N)

Decisive input
period

(N+1)

Decisive input
period

(N+2)

$D_{OUT}$

Decisive output
period

(N-1)

(N) Decisive output
priod

Output
delay time

Access time from clock

EP 0 498 895 A1

# Fig. 5

# Fig. 6

Fig.7

Fig.8(a) $\overline{CS}$

Fig.8(b) CLK

Fig.8(c) CLK1

Fig.8(d) CLK2

Fig.8(e) Cell output

Fig.8(f) S X A output

Fig.8(g) Level Conversion output (N-1) (N) (N+1)

Fig.8(h) Ⓐ (R-2) (R-4)

Fig.8(i) Ⓑ ① (N-1) ③ (N) ⑤ (N+1)

Fig.8(j) Ⓒ (R-1) (R-3)

Fig.8(k) Ⓓ ② (N-1) ④ (N)

Level conversion output → Ⓐ | Latch circuit 2 | Ⓑ CLK1 Ⓒ | Latch circuit 1 | Ⓓ → D_OUT

14

Fig. 9

# Fig.10(A)

# Fig.10(B-1)

# Fig.10(B-2)

# Fig.10(C)

EP 0 498 895 A1

Fig.11

# Fig.12

EP 0 498 895 A1

# INTERNATIONAL SEARCH REPORT

**I. CLASSIFICATION OF SUBJECT MATTER** (if several classification symbols apply, indicate all) ⁶

According to International Patent Classification (IPC) or to both National Classification and IPC

Int. Cl$^5$  H03K5/15, G06F1/04, G11C11/34

**II. FIELDS SEARCHED**

| Minimum Documentation Searched ⁷ | |
|---|---|
| Classification System | Classification Symbols |
| IPC | H03K3/037, H03K5/15, G11C11/34 |

Documentation Searched other than Minimum Documentation
to the Extent that such Documents are Included in the Fields Searched ⁸

| | |
|---|---|
| Jitsuyo Shinan Koho | 1926 - 1991 |
| Kokai Jitsuyo Shinan Koho | 1971 - 1991 |

**III. DOCUMENTS CONSIDERED TO BE RELEVANT** ⁹

| Category * | Citation of Document, ¹¹ with indication, where appropriate, of the relevant passages ¹² | Relevant to Claim No. ¹³ |
|---|---|---|
| Y | JP, A, 50-152649 (Matsushita Electric Ind. Co., Ltd.), December 8, 1975 (08. 12. 75), Fig. 3 (Family: none) | 1-10 |
| Y | JP, A, 62-188516 (NEC Corp.), August 18, 1987 (18. 08. 87), Fig. 4 (Family: none) | 1-10 |
| Y | JP, A, 61-264817 (Fujitsu Ltd.), November 22, 1986 (22. 11. 86), Fig. 1 (Family: none) | 1-10 |
| Y | JP, A, 1-300493 (Ricoh Co., Ltd.), December 4, 1989 (04. 12. 89), Fig. 1 (Family: none) | 2-10 |
| Y | JP, A, 2-137189 (Hitachi, Ltd.), May 25, 1990 (25. 05. 90), Lines 5 to 17, upper left column, page 4, Figs. 1, 8, 10, 17 (Family: none) | 2-10 |

* Special categories of cited documents: ¹⁰

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| November 8, 1991 (08. 11. 91) | November 25, 1991 (25. 11. 91) |
| International Searching Authority | Signature of Authorized Officer |
| Japanese Patent Office | |

Form PCT/ISA/210 (second sheet) (January 1985)

FURTHER INFORMATION CONTINUED FROM THE SECOND SHEET

| Y | JP, A, 1-241913 (Fujitsu Ltd.),<br>September 26, 1989 (26. 09. 89),<br>Line 4, lower left column, page 1 to<br>line 10, lower left column, page 2,<br>Figs. 1, 2 (Family: none) | 2-10 |
| Y | JP, A, 60-254488 (Mitsubishi Electric<br>Corp.),<br>December 16, 1985 (16. 12. 85),<br>Figs. 1, 6, 8 (Family: none) | 2-10 |

**V. ☐ OBSERVATIONS WHERE CERTAIN CLAIMS WERE FOUND UNSEARCHABLE** [1]

This international search report has not been established in respect of certain claims under Article 17(2) (a) for the following reasons:

1. ☐ Claim numbers          , because they relate to subject matter not required to be searched by this Authority, namely:

2. ☐ Claim numbers          , because they relate to parts of the international application that do not comply with the prescribed requirements to such an extent that no meaningful international search can be carried out, specifically:

3. ☐ Claim numbers          , because they are dependent claims and are not drafted in accordance with the second and third sentences of PCT Rule 6.4(a).

**VI. ☐ OBSERVATIONS WHERE UNITY OF INVENTION IS LACKING** [2]

This International Searching Authority found multiple inventions in this international application as follows:

1. ☐ As all required additional search fees were timely paid by the applicant, this international search report covers all searchable claims of the international application.

2. ☐ As only some of the required additional search fees were timely paid by the applicant, this international search report covers only those claims of the international application for which fees were paid, specifically claims:

3. ☐ No required additional search fees were timely paid by the applicant. Consequently, this international search report is restricted to the invention first mentioned in the claims; it is covered by claim numbers:

4. ☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.